# FASCICULE DE BREVET EUROPEEN

(11) **EP 1 966 888 B1**
(45) Date de publication et mention de la délivrance du brevet: **01.09.2010**
(21) Numéro de dépôt: 06847102.8
(22) Date de dépôt: 21.12.2006
(51) Int. Cl.: H03K 3/57

(54) **GENERATEUR D'IMPULSIONS ELECTRIQUES DE FORTE PUISSANCE**
HOCHLEISTUNGSGENERATOR FÜR ELEKTRISCHE IMPULSE
HIGH POWER ELECTRIC PULSE GENERATOR

(30) Priorité: 29.12.2005 FR 0554138
(43) Date de publication de la demande: 10.09.2008
(73) Titulaire: CENTRE NATIONAL DE LA RECHERCHE SCIENTIFIQUE (CNRS), 75794 Paris Cedex 16 (FR); Universite De Limoges, 87032 Limoges (FR)
(72) Inventeur: COUDERC, Vincent, F-87430 Verneuil-sur-Vienne (FR); VERGNE, Bertrand, F-87000 Limoges (FR); BARTHELEMY, Alain, F-87000 Limoges (FR); GONTIER, Dominique, F-92290 La Norville (FR); BRUNEL, Patrick, F-94520 Mandres les Roses (FR)
(74) Mandataire: Novagraaf Technologies
(86) Numéro de dépôt international: PCT/FR2006/002825
(87) Numéro de publication internationale: WO 2007/074229

(56) Documents cités:
- FR-A- 2 679 716
- DANIELSSON B E: "HVDC valve with light-triggered thyristors" AC AND DC POWER TRANSMISSION, 1991., INTERNATIONAL CONFERENCE ON LONDON, UK, LONDON, UK,IEE, UK, 1991, pages 159-164, XP006516007 ISBN: 0-85296-517-6
- ANDERSON N C: "Photoconductive power switches" BRITISH AEROSPACE RESEARCH CENTRE, 1992, pages 4-1, XP006522236

## Description

La présente invention se rapporte au domaine des générateurs d'impulsions électriques de forte puissance.

La présente invention se rapporte plus particulièrement à un générateur d'impulsions haute tension comprenant un moyen de stockage de charges, une source haute tension apte à charger ledit moyen de stockage de charges, un premier élément photoconducteur relié d'une part à la référence des potentiels et d'autre part audit moyen de stockage, un second élément photoconducteur relié d'une part audit moyen de stockage, et d'autre part à une charge utile, une première source lumineuse apte à délivrer une impulsion lumineuse audit premier photoconducteur, une seconde source lumineuse apte à délivrer une impulsion lumineuse audit second photoconducteur, et un moyen de synchronisation du retard d'émission entre la première source lumineuse et la seconde source lumineuse.

Ce type de générateur d'impulsions électriques est dit à onde gelée et permet de façon connue, d'obtenir des signaux bipolaires ou des trains d'impulsions de polarisation alternée de durée quelconque en théorie.

Dans ce type de générateur, les photoconducteurs utilisés sont des substrats semiconducteurs de nature diverse. Les plus couramment employés sont dit fonctionnant en régime « avalanche ».

L'inconvénient de ces systèmes à photoconducteur travaillant en régime avalanche, est la gigue temporelle importante qui est classiquement trop grande pour synchroniser des impulsions courtes (subnanoseconde). Cette gigue temporelle des démarrages des deux ondes (ou « jitter » en anglais) limite fortement les possibilités de contrôle du signal bipolaire désiré, et donc du spectre de ce dernier.

De plus le régime avalanche ne permet pas d'obtenir des impulsions reproductibles et ce à cause du caractère chaotique impliqué par le phénomène qui de surcroît limite la durée de vie des photocommutateurs par destruction locale du substrat (phénomène de filamentation dans les systèmes avalanche).

Afin d'obtenir des impulsions électrique de forte puissance, d'une courte durée, typiquement de l'ordre de la nanoseconde ou en dessous, il est connu d'utiliser des commutateurs optoélectroniques.

La demande FR 2 679 716 décrit par exemple un système générant une impulsion comprenant une source de haute tension continue, un condensateur, qui est chargé par la source, et qui est destiné à être relié à une charge par l'intermédiaire d'une liaison électrique adaptée à la charge, et un élément semiconducteur passif formant un commutateur photosensible qui se ferme lorsque l'élément photoconducteur reçoit une impulsion lumineuse, et qui est ouvert en l'absence d'impulsion lumineuse. La fermeture de ce commutateur provoque la décharge du condensateur et donc la formation d'une impulsion de haute tension qui alimente la charge. L'intégration et la nature de l'élément semi-conducteur permettent alors d'obtenir de bonnes performances sur l'impulsion, typiquement une impulsion dont le temps de montée (ou de descente) est très court et vaut par exemple moins de 100 picosecondes (ps) pour 2 kV.

Ce dispositif possède cependant un certain nombre d'inconvénients.

D'abord, on comprend que le dispositif décrit dans la demande FR 2 679 716 permet de générer que des impulsions soit négatives, soit positives, selon la polarisation de la source haute tension. Ceci conduit à une répartition de la puissance du spectre de l'impulsion limitée aux basses fréquences, et ne permet pas le contrôle et la maîtrise de ce spectre.

Or, il est avantageux de maîtriser le profil du spectre électrique en fonction des besoins.

En particulier, dans le domaine de la biologie, si l'on applique une haute tension à des cellules vivantes, l'application d'une tension uniquement positive ou uniquement négative risque de provoquer un éclatement de la cellule par création d'un champ de force au sein de la cellule.

Il serait donc avantageux de remédier à ces inconvénients en proposant un générateur d'impulsions électriques dans lequel l'impulsion pourrait être successivement positive et négative sur le temps d'impulsion, et pour lequel on puisse maîtriser le profil spectral du signal généré, tout en gardant une durée d'impulsion très courte, typiquement subnanoseconde pour des tensions crête-à-crête de 3kV ou plus et avec des énergies optiques faibles pour pouvoir cumuler la puissance de plusieurs générateurs.

Un des buts de la présente invention est donc de permettre la génération d'un monocycle ajustable temporellement et donc spectralement.

Un autre but de la présente invention est de permettre une grande reproductibilité de la source.

Un autre but de la présente invention est d'obtenir une amplitude crête-à-crête de plusieurs kilovolts pour une durée du signal bipolaire subnanoseconde.

Un autre but de la présente invention est de fournir un système de durée de vie très élevé avec une faible consommation d'énergie optique.

À cet effet, on prévoit, selon l'invention, un générateur d'impulsions haute tension tel que mentionné ci-dessus qui, outre les caractéristiques déjà mentionnées, est caractérisé par le fait que ledit premier photoconducteur et ledit second photoconducteur sont des éléments semi-conducteur passifs en régime linéaire formant des commutateurs photosensibles, lesdits premiers et second photoconducteurs étant des photoconducteurs passifs en silicium dopé.

L'utilisation de semi-conducteurs passifs en régime linéaire se comportant comme des commutateurs permet alors, de par leurs réactivités aux impulsions émises par les lasers, d'obtenir une gigue temporelle très faible, qui, en combinaison avec le moyen de synchronisation entre les sources, permet de contrôler finement la modulation du spectre du signal délivré par le générateur.

L'utilisation du régime linéaire permet également d'obtenir des signaux d'une grande reproductibilité. Et la durée de vie des composants photosensibles est théoriquement illimitée dans ce régime de fonctionnement.

Par ailleurs, l'utilisation d'une diode en silicium fournit un temps de recombinaison des porteurs qui permet une minimisation du jitter au niveau du déclenchement.

Un inconvénient du régime linéaire est sa grande consommation d'énergie optique. C'est pourquoi nous proprosons un type de semiconducteur photosensible en silicium permettant de réduire d'un facteur 10 à 100 cette dernière grâce à un dopage n et p et un agencement des semi-conducteurs de type diode.

On comprendra mieux l'invention à l'aide de la description, faite ci-après à titre purement explicatif, d'un mode de réalisation de l'invention, en référence aux figures annexées où :
- la figure 1 illustre diagramme schématique illustrant le générateur haute tension selon l'invention;
- la figure 2 illustre le régime de fonctionnement des semi-conducteurs selon l'invention ;
- la figure 3 illustre un monocycle équilibré obtenu par un générateur selon la présente invention ;
- la figure 4 illustre un monocycle déséquilibré obtenu par un générateur selon la présente invention.

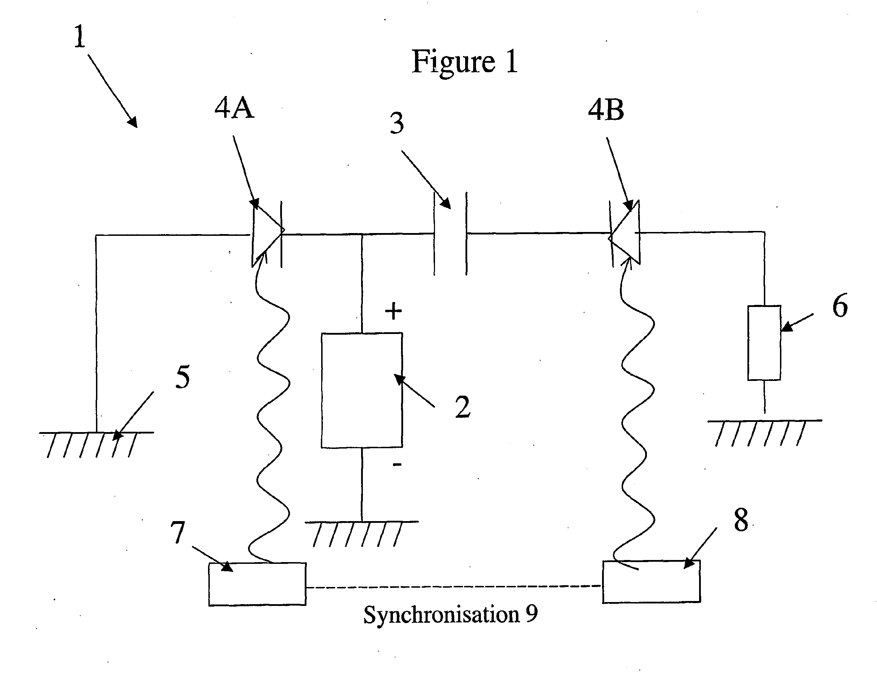

Illustré figure 1, le générateur 1 comprend une source de haute tension 2 et une ligne de transmission hyperfréquence formant un moyen de stockage de charges 3. Il comprend également deux semiconducteurs 4A et 4B de part et d'autre de la ligne de transmission 3. Le premier semiconducteur 4A est relié à la référence des potentiels 5 et le second semiconducteur est relié à une charge utile 6. Les semi-conducteurs 4A et 4B sont susceptibles d'être excités par deux sources lumineuses 7 et 8, qui sont couplés par un moyen de synchronisation 9. Ce moyen de synchronisation 9 permet de contrôler le retard des émissions lasers issues des sources 7 et 8. Les sources 7 et 8 peuvent être constituées d'une source laser dont on scinde en deux le rayonnement ou par deux sources laser synchrones.

Lorsque les sources 7 et 8 n'éclairent pas les composants semi-conducteurs 4A et 4B, ceux-ci présentent une résistance propre importante de plusieurs dizaines de Mégohms qui peuvent être considérés comme des commutateurs ouverts. Après illumination par une impulsion optique brève issue des sources 7 et 8, la résistance des composants éclairés est sensiblement diminuée et est proche de quelques ohms voir moins. Le commutateur est alors fermé et cette fermeture est d'autant plus efficace que l'énergie optique est absorbée. Cette réduction de la résistance interne du composant permet la libération instantanée de l'énergie contenue dans la ligne de transmission 3, à la vitesse de réactivité près de ce dernier. L'onde stationnaire contenue dans la ligne du générateur est alors libérée. Les fronts de cette onde stationnaire se propageant alors dans les deux directions opposées.

Le front d'onde se propageant directement vers la charge 6 à une tension de même signe que celle de la tension de polarisation appliquée à la ligne de transmission 3. La partie de cette onde se propageant directement vers la référence des potentiels 5 va se réfléchir avec une inversion de sa polarisation. Une impulsion de signe opposé à celui de la tension de polarisation est alors engendrée et suit directement la première impulsion de même signe que celui de la tension de polarisation. L'association des deux signaux forme alors un signal bipolaire.

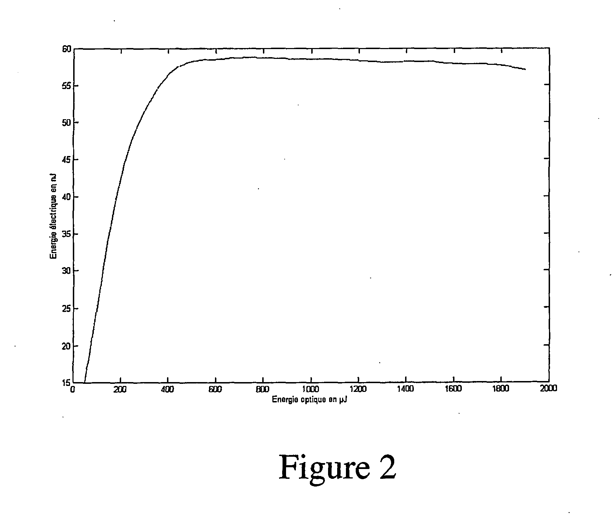

On décrit maintenant les caractéristiques des semi-conducteurs 4A et 4B selon l'invention. Ces semi-conducteurs 4A et 4B sont agencés pour fonctionner dans un régime linéaire tel qu'illustré dans la partie linéaire de la figure 2. Dans ce régime, l'énergie électrique commutée dépend linéairement de l'énergie optique absorbée par le semi-conducteur.

La linéarité de cette courbe de réponse prouve le mode de fonctionnement linéaire des photocommutateurs 4A et 4B, ce qui permet une synchronisation du déclenchement des deux commutateurs optiques avec une gigue temporelle négligeable, typiquement inférieure à 2ps.

De plus, ces semiconducteurs dopés n et p nécessitent peu d'énergie optique lors de leur commutation et de posséder un temps de recombinaison des porteurs long devant la durée du signal voulant être engendré, typiquement 350 nanosecondes.

Un exemple de semi-conducteur en silicium dopé n-p permettant de réduire la gigue temporelle selon l'invention est par exemple donné dans la publication de Philips Semi-conductors « BYX90G High-Voltage soft-recovery controlled avalanche rectifier ».

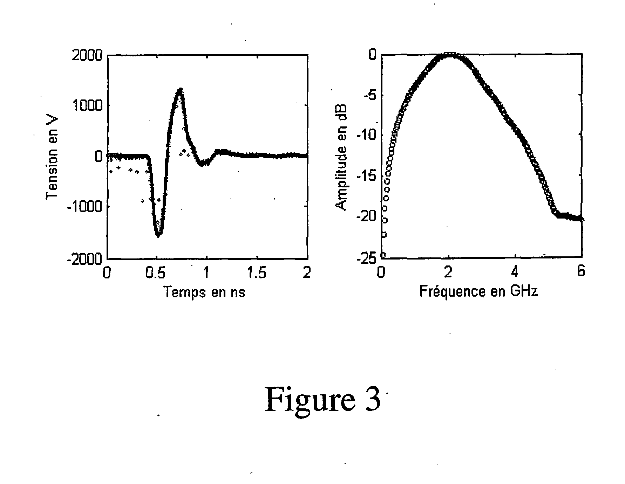

Illustré figure 3, le générateur selon l'invention permet donc d'obtenir un monocycle équilibré, c'est-à-dire de valeur moyenne quasiment nulle si les signaux des deux sources lumineuse arrivent en même temps sur les deux photocommutateurs.

Le moyen de synchronisation 9 permet également de décaler les instants de fermeture des commutateurs 4A et 4B afin de moduler le signal de sortie.

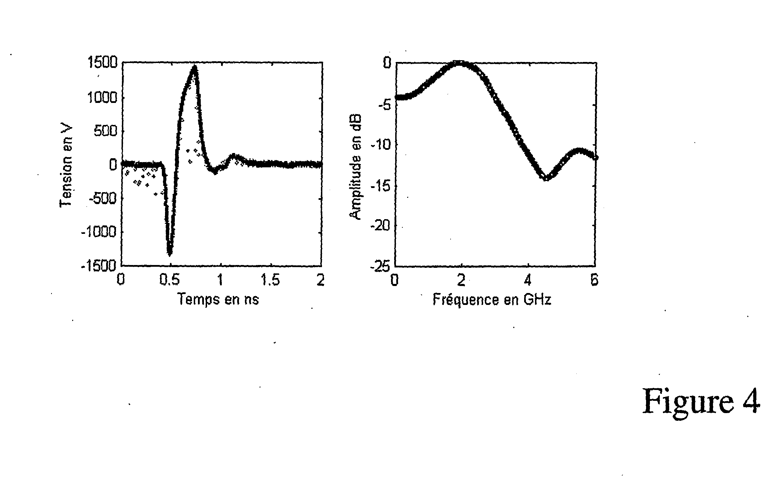

Illustré figure 4, on observe un signal sur lequel la durée d'émission du signal positif est supérieur à la durée d'émission du signal négatif. Le spectre associé peut donc être modulé par le moyen de synchronisation 9.

On note que dans l'art antérieur, un tel contrôle du signal bipolaire et du spectre associé était impossible pour des signaux de cette puissance car la gigue temporelle intrinsèque du régime avalanche ne permettait pas une reproductibilité suffisante du profil des impulsions subnanosecondes. A titre indicatif, la figure 6 représente un diagramme comparatif des temps de réponse à une excitation optique entre un semi-conducteur dopé en régime linéaire selon l'invention et un photoconducteur à avalanche selon l'art antérieur.

De préférence, les semi-conducteurs 4A et 4B sont dopés différemment. Le dopage est constitué par un excès de charges positives et négatives périodique de type n-p. Une période unique de dopage constitue alors une jonction de type diode. Cette diode montée en inverse par rapport à la polarisation de l'élément chargé 3 et se comporte donc comme un commutateur ouvert en absence d'excitation lumineuse.

La ligne de transmission 3 peut être du type : ligne coaxiale, microruban, microstrip, ou tout type de ligne de propagation hyperfréquence.

Les semi-conducteurs 4A et 4B sont isolés de façon importante par rapport au potentiel par le biais d'un diélectrique isolant comme de l'air, de la silicone, de la colle ou du téflon de manière adapter l'impédance local du composant au mieux à celle de la ligne de transmission 3 et à celle du connecteur de sortie.

Enfin, les semi-conducteurs 4A et 4B sont dopés n-p de telle sorte qu'ils peuvent tenir une tension de polarisation jusqu'à 10 kV et de préférence jusqu'à 16 kV, permettant de commuter une tension crête de plus de 10kV crête avec une énergie optique par impulsion de l'ordre de 1.5mJ ce qui représente environ 10 à 100 fois l'énergie communément utilisée en régime linéaire pour commuter de telles tensions.

## Revendications

1. Générateur d'impulsion haute tension comprenant un moyen de stockage de charge (3), une source haute tension (2) apte à alimenter en charge ledit moyen de stockage de charge, un premier élément photoconducteur (4A) relié d'une part à la référence des potentiels et d'autre part audit moyen de stockage, un second élément photoconducteur (4B) relié d'une part audit moyen de stockage, et d'autre part à une charge utile (6), une première source lumineuse (7) apte à délivrer une impulsion lumineuse audit premier photoconducteur, une seconde source lumineuse (8) apte à délivrer une impulsion lumineuse audit second photoconducteur, et un moyen de synchronisation du retard d'émission entre la première source lumineuse et la seconde source lumineuse, **caractérisé en ce que** ledit premier photoconducteur et ledit second photoconducteur sont des éléments semi-conducteur passifs en régime linéaire formant des commutateurs photosensibles, lesdits premiers et second photoconducteurs étant des photoconducteurs en silicium dopé.

2. Générateur d'impulsion haute tension selon la revendication 1 dans lequel ladite première source lumineuse et ladite seconde source lumineuse sont issues d'un laser unique.

3. Générateur d'impulsion haute tension selon la revendication 1 dans lequel ladite première source lumineuse est issue d'un premier laser et ladite seconde source lumineuse est issue d'un second laser.

4. Générateur d'impulsion haute tension selon la revendication 1 dans lequel ledit moyen de stockage de charge (3) est une ligne de transmission.

## Claims

1. High-voltage pulse generator comprising a charge storage means (3), a high-voltage source (2) able to supply charge to said charge storage means, a first photoconductor element (4A) linked on the one hand to the reference of the potentials and on the other hand to said storage means, a second photoconductor element (4B) linked on the one hand to said storage means, and on the other hand to a payload (6), a first light source (7) able to deliver a light pulse to said first photoconductor, a second light source (8) able to deliver a light pulse to said second photoconductor, and a means of synchronizing the transmission delay between the first light source and the second light source, **characterized in that** said first photoconductor and said second photoconductor are linear mode passive semiconductor elements forming photosensitive switches, said first and second photoconductors being photoconductors made of doped silicon.

2. High-voltage pulse generator according to Claim 1, in which said first light source and said second light source are derived from a single laser.

3. High-voltage pulse generator according to Claim 1, in which said first light source is derived from a first laser and said second light source is derived from a second laser.

4. High-voltage pulse generator according to Claim 1, in which said charge storage means (3) is a transmission line.

## Patentansprüche

1. Impuls-Hochspannungsgenerator mit einer Ladungsspeichereinrichtung (3), einer Hochspannungsquelle (2), die so ausgelegt ist, dass diese die Ladungsspeichereinrichtung mit einer Ladung versorgt, einem ersten Fotoleiterelement (4A), das einerseits mit der Bezugsgröße der Potentiale und andererseits mit der Speichereinrichtung verbunden ist, einem zweiten Fotoleiterelement (4B), das einerseits mit der Speichereinrichtung und andererseits mit einer Nutzlast (6) verbunden ist, einer ersten Lichtquelle (7), die so ausgelegt ist, dass sie einen Lichtimpuls an den ersten Fotoleiter liefert, einer zweiten Lichtquelle (8), die so ausgelegt ist, dass diese einen Lichtimpuls an den zweiten Fotoleiter liefert, und einer Synchronisationseinrichtung der Emissionsverzögerung zwischen der ersten Lichtquelle und der zweiten Lichtquelle, **dadurch gekennzeichnet, dass** der erste Fotoleiter und der zweite Fotoleiter passive Halbleiterelemente in linearem Zustand sind, die lichtempfindliche Schaltglieder bilden, wobei der erste und zweite Fotoleiter aus dotiertem Silizium sind.

2. Impuls-Hochspannungsgenerator nach Anspruch 1, in welchem die erste Lichtquelle und die zweite Lichtquelle von einem einzigen Laser kommen.

3. Impuls-Hochspannungsgenerator nach Anspruch 1, in welchem die erste Lichtquelle von einem ersten Laser kommt und die zweite Lichtquelle von einem zweiten Laser kommt.

4. Impuls-Hochspannungsgenerator nach Anspruch 1, in welchem die Ladungsspeichereinrichtung (3) eine Übertragungsleitung ist.
